# EUROPEAN PATENT APPLICATION

(11) **EP 4 722 750 A1**
(43) Date of publication of application: **08.04.2026**
(21) Application number: 24204871.8
(22) Date of filing: 07.10.2024
(51) Int. Cl.: G01R 33/28, G01R 33/385

(54) **SAFETY MONITORING FOR GRADIENT CHAIN OF MAGNETIC RESONANCE SYSTEM**

(71) Applicant: Koninklijke Philips N.V., 5656 AG Eindhoven (NL)
(72) Inventor: LIPS, Oliver, Eindhoven (NL); VERNICKEL, Peter, Eindhoven (NL)
(74) Representative: Philips Intellectual Property & Standards

(57) **Abstract**

A safety monitoring method for a gradient chain of a magnetic resonance examination system comprises:
applying (S1) an input gradient waveform to the gradient chain at a set time period,
determining (S2) a predicted output of the gradient chain which is induced by the input gradient waveform, on the basis of a predetermined frequency dependent impedance value of the gradient chain which has been predetermined by measuring transfer functions of the gradient chain for different frequencies before the set time period,
measuring (S3) the actual output of the gradient chain which is induced by the input gradient waveform,
comparing (S4) the actual output with the predicted output, and
triggering (SS) a corrective action if the comparing (S4) has indicated a difference beyond a predefined admissible difference.

In this way, the safety monitoring method can reliably detect and mitigate electrical faults, such as broken conductors or loose contacts, to prevent sustained electrical arcing and thereby enhance the safety and integrity of the MR equipment, as well as protect patients and medical personnel.

## Description

### FIELD OF THE INVENTION

The invention relates to the field of magnetic resonance (MR) examination technology, with a particular focus on safety monitoring for a gradient chain of a magnetic resonance examination system.

### BACKGROUND OF THE INVENTION

Magnetic resonance examination technology, particularly magnetic resonance imaging (MRI), has become a cornerstone in the medical field for its ability to produce detailed, high-resolution images of the interior of the human body. This non-invasive imaging technique is especially effective for visualizing soft tissues, making it indispensable in the diagnosis and monitoring of various medical conditions. The underlying principle of MRI relies on the application of strong magnetic fields, radiofrequency pulses, and gradient fields to generate these detailed images.

The MRI process begins with the alignment of hydrogen nuclei in the body, primarily found in water and fat, along the direction of a strong external magnetic field. When a radiofrequency pulse is applied, these aligned nuclei are momentarily disturbed, causing them to emit signals as they return to their original alignment. These emitted signals are detected and processed to form an image. However, in order to accurately map the location of the signals within the body, the MRI system uses gradient coils to spatially vary the magnetic field. These gradient coils are critical components, as they allow the MRI system to encode spatial information into the signals, thereby enabling the generation of accurate images.

Gradient coils operate by producing rapidly changing magnetic fields, which are superimposed on the main magnetic field. This operation requires the handling of substantial electrical currents and voltages, often reaching into the megawatt (MW) range. Consequently, the power demands of gradient coils are significant, and the associated power supplies must be robust to handle these extreme loads. However, the operation of gradient coils under such conditions is not without risks.

One of the primary concerns with the operation of gradient coils is the potential for electrical faults within the gradient chain, which includes the coils, power supplies, and associated circuitry. A particular area of risk involves the possibility of a broken conductor or a loose contact within the system. These faults, although relatively rare, can lead to sustained electrical arcing - a dangerous condition where electrical current flows through an unintended path. Sustained arcing can result in significant localized energy deposition, which poses the risk of severe damage to the MRI equipment and the potential for fires. Such incidents not only threaten the integrity of the expensive MRI system but also endanger the safety of patients and medical personnel.

Given the critical role of gradient coils in the MRI process and the severe consequences that can arise from their malfunction, there is a pressing need for improved safety monitoring techniques within MRI technology.

US 2019/0369183 A1 describes a diagnostic device for diagnosing a faulty condition in a gradient amplifier system. The diagnostic device includes a first current sensor configured to be coupled to an input terminal of a filter unit, where the first current sensor is configured to measure a first electric current at the input terminal of the filter unit, and where the first electric current includes a high current component and a low frequency current component. Further, the diagnostic device includes a diagnostic unit coupled to the first current sensor and configured to determine an impedance across the filter unit and a load unit based on the low frequency current component of the measured first electric current and a prestored reference voltage, and diagnose the faulty condition of at least one component in at least one of the filter unit and the load unit based on a characteristic of the determined impedance.

### SUMMARY OF THE INVENTION

It is an object of the invention to provide an improved safety monitoring method for the gradient chain of a magnetic resonance examination system, which can reliably detect and mitigate electrical faults, such as broken conductors or loose contacts, to prevent sustained electrical arcing and thereby enhance the safety and integrity of the MRI equipment, as well as protect patients and medical personnel.

The invention is defined by the independent claims. Advantageous embodiments are defined in the dependent claims.

According to one embodiment of the invention, a safety monitoring method for a gradient chain of a magnetic resonance examination system is provided, the method comprising:
applying an input gradient waveform current to the gradient chain of a magnetic resonance examination system at a set time period,
determining a predicted output voltage of the gradient chain which is induced by the gradient waveform current which is applied to the gradient chain at the set time period on the basis of a predetermined frequency dependent impedance value of the gradient chain which has been predetermined by measuring transfer functions of the gradient chain for different frequencies before the set time period,
measuring the actual output voltage of the gradient chain which is induced by the gradient waveform current which is applied to the gradient chain at the set time period,
comparing the actual output voltage with the predicted output voltage, and
triggering a corrective action in case the comparing the actual output voltage with the predicted output voltage has indicated a difference beyond a predefined admissible difference in the comparing the actual output voltage with the predicted output voltage.

Reliable detection of arcing in the gradient circuit is essential. One conventional approach to achieve this is by monitoring the associated currents and voltages. However, a challenge lies in the fact that, during normal operation, the currents and voltages in the gradient coil fluctuate rapidly and across a wide range. This makes it difficult to immediately distinguish between a steep voltage increase that results from an intended change in current and a similar increase caused by a loose connection. Accurate differentiation can be achieved by ensuring that the observed voltage and current traces align with the expected impedance of the gradient coil, which includes not only the coil itself but also the associated cables, connections, and filters.

According to the invention it has been realized that a critical factor in this analysis is that the impedance of the gradient coil is highly dependent on frequency, a complexity that, according to the invention, is considered for accurate monitoring. Conventional techniques often rely on simplified models, assuming that the inductance (L) and resistance (R) are independent of frequency or apply other simplifying assumptions. These simplifications result in less reliable predictions, which are often only accurate in limited or "favorable segments" of the waveform.

In contrast, the proposed method overcomes these limitations by using measured, frequency-dependent parameters of the gradient coil. Therefore, the invention allows for detecting voltages that do not match the impedance of the gradient coil. This approach enables efficient, near real-time calculation of the expected voltages for any given waveform, leading to more reliable detection and differentiation of potential faults in the gradient circuit. The present invention addresses the need for improved safety monitoring techniques within MRI technology by providing advanced mechanisms for monitoring the operational safety of MRI gradient coils, aiming to prevent or mitigate the risks associated with electrical faults in the gradient chain.

Although the examples of the method are described with an input current and output voltage, it can be understood that the method may instead, mutatis mutandis, use an input voltage and output current. I.e., alternatively, an input waveform voltage may be applied to the gradient chain, and output current may be predicted, measured and compared.

The safety monitoring method according to the invention may be a computer-implemented method.

The predetermining of the frequency dependent impedance value may be separate from the method of the invention, and which especially is done with a device which is different from the device or system which is used for the method of the invention. However, the predetermining of the frequency dependent impedance value may also be part of the method of the invention.

Therefore, according to an embodiment of the invention, the predetermining the frequency dependent impedance value of a gradient chain is performed by measuring transfer functions of the gradient chain for different frequencies before the set time period.

According to an embodiment of the invention, the predetermining the frequency dependent impedance value of a gradient chain by measuring transfer functions of the gradient chain for different frequencies before the set time period comprises applying a series of currents having different time durations as gradient waveform currents which are applied to the gradient chain. The currents may have trapezoid or triangle waveforms of different lengths with different slopes and chirps. Further, pulses which resemble δ-pulses are highly suitable, too.

This embodiment allows for a comprehensive analysis of the gradient chain's behavior across different frequencies by simulating the conditions it will experience during actual operation. By using currents with different time durations, the system can observe how the gradient chain responds to a range of electrical inputs, capturing the impedance characteristics under diverse operating conditions. This approach ensures that the frequency-dependent impedance is accurately mapped, providing a detailed profile of how the system behaves across the spectrum of frequencies that it may encounter.

The primary function of this embodiment is to create a precise and thorough understanding of the gradient chain's impedance characteristics before the monitoring period begins. This data is important for establishing a baseline against which real-time measurements can be compared during the operation of the MRI system.

The advantages of this embodiment are significant in enhancing the safety and reliability of the MRI system. Firstly, it allows for early detection of anomalies or deviations in the gradient chain's behavior, which could suggest potential faults such as broken conductors or loose contacts. Detecting these issues before they manifest as more serious problems helps to prevent dangerous conditions like sustained electrical arcing, thereby protecting both the MRI equipment and the safety of patients and medical personnel. Additionally, by providing a detailed understanding of the gradient chain's impedance characteristics, this method enhances the accuracy of the safety monitoring process, enabling the system to respond more effectively to any abnormalities detected during operation. This proactive approach not only improves the overall safety of the MRI system but also contributes to its longevity and reliability by preventing damage and reducing the risk of operational failures.

According to an embodiment of the invention, the comparing the actual output voltage with the predicted output voltage comprises
comparing the actual output voltage with the predicted output voltage with respect to relative values of the actual output voltage and the predicted output voltage and/or
comparing the actual output voltage with the predicted output voltage with respect to absolute values of the actual output voltage and the predicted output voltage.

This dual approach to comparison serves to enhance the accuracy and reliability of the safety monitoring system. The function of comparing the actual output voltage with the predicted output voltage in relative terms is to assess the proportional difference between the two voltages. This means evaluating how much the actual output voltage deviates from the predicted voltage as a percentage or ratio. This relative comparison is useful for detecting smaller discrepancies that might indicate subtle issues in the gradient chain, such as minor faults or gradual degradation in performance, which could potentially lead to more serious problems if left unchecked. Moreover, a relative deviation can be helpful for high voltage values, where minor changes in the system (e. g. due to thermal drifts) can already lead to higher absolute deviations, which, however, are not to be considered as dangerous.

On the other hand, the absolute value comparison focuses on the direct numerical difference between the actual and predicted voltages. This method is particularly effective for identifying significant deviations that exceed predetermined thresholds, signaling more immediate and possibly dangerous faults, such as a broken conductor or a severe electrical malfunction. By comparing the absolute values, the system can quickly detect and respond to critical issues that could compromise the safety and functionality of the MRI system. Absolute differences may be helpful for lower voltages, where measurement noise can already lead to substantial relative deviations.

Advantages of this embodiment lie in the comprehensive nature of the voltage comparison. By incorporating both relative and absolute value comparisons, the safety monitoring method is equipped to detect a wide range of potential faults, from minor inconsistencies to major malfunctions. This layered approach enhances the robustness of the monitoring system, ensuring that even subtle deviations that might be overlooked by one method are captured by the other. As a result, the system can provide a more accurate and timely detection of faults, reducing the risk of damage to the MRI equipment and ensuring the safety of both patients and medical personnel. Additionally, this dual comparison method allows for more nuanced diagnostics, enabling the system to differentiate between different types of faults and respond appropriately, whether that means issuing a warning, triggering a shutdown, or taking other corrective actions to maintain the safe operation of the MRI system. The deviation of predicted and measured voltage can be smoothed/averaged over time in order to look for sustaining differences.

In this respect, according to an embodiment of the invention, in the comparing the actual output voltage with the predicted output voltage with respect to relative values of the actual output voltage and the predicted output voltage and/or in the comparing the actual output voltage with the predicted output voltage with respect to absolute values of the actual output voltage and the predicted output voltage, a comparison is made in dependence on the absolute value of the current which is applied to the gradient chain at the set time period and/or the predicted output voltage.

According to this embodiment, the comparison takes into account the specific current level being used when the voltages are compared. The primary function of this approach is to enhance the accuracy and relevance of the voltage comparison by considering the influence of the current on the gradient chain's behavior. Since the relationship between current and voltage is fundamental in electrical systems, incorporating the current value into the comparison ensures that any deviations detected are accurately attributed to potential faults rather than natural variations in the system due to different current levels. For instance, higher currents might naturally lead to higher output voltages, so by factoring in the current, the system avoids false positives that could arise from normal operating conditions.

The advantage of this embodiment is that it improves the precision of fault detection in the safety monitoring process. By adjusting the comparison based on the current applied, the system can more accurately differentiate between expected variations in voltage due to normal current fluctuations and actual faults that could pose safety risks. This results in fewer false alarms and ensures that the system responds appropriately to genuine issues, enhancing both the safety and reliability of the MRI system. Additionally, this approach allows for more tailored monitoring, as it ensures that the comparison is relevant to the specific operating conditions at any given time, leading to more effective detection and prevention of potential faults.

According to an embodiment of the invention, the corrective action comprises triggering a current supply of the gradient chain to switch off. This is a safety measure designed to prevent further damage to the MRI system and to protect both the equipment and the individuals involved. The primary function of this corrective action is to immediately halt the flow of current through the gradient chain when a potential fault, such as a significant deviation in output voltage, is detected. By cutting off the current supply, the system effectively stops the operation of the gradient coils, preventing any further electrical activity that could exacerbate the fault or lead to dangerous conditions such as electrical arcing, overheating, or even fires. The advantages of this embodiment are significant in terms of safety and equipment protection. By quickly switching off the current supply, the system can prevent minor faults from escalating into major failures that could damage the MRI machine or pose risks to patient and staff safety. This immediate response minimizes the risk of catastrophic events and ensures that the MRI system can be inspected, repaired, or reset without sustaining serious damage. Additionally, this proactive approach helps to maintain the longevity and reliability of the MRI system by preventing stress or damage to the gradient chain, which can be caused by continued operation under faulty conditions. Overall, this embodiment enhances the safety and robustness of the MRI system, ensuring a swift and effective response to any detected faults.

According to an embodiment of the invention, a method as described above may be applied to a gradient chain which comprises at least a gradient coil. In this case, the frequency dependent impedance value of the gradient chain could be the frequency dependent impedance value of the gradient coil alone, e. g. the "voltage reaction" of the gradient coil to the current supplied to the gradient coil by a gradient amplifier connected upstream to the gradient coil. Therefore, in this case the gradient amplifier is not part of the gradient chain for which the frequency dependent impedance value is predetermined.

According to an embodiment of the invention, the gradient chain comprises a gradient amplifier which is connected upstream to the gradient coil. In this case, the frequency dependent impedance value of the gradient chain could be the frequency dependent impedance value of the gradient coil together with the gradient amplifier, e. g. the "voltage reaction" of the gradient coil to the demand current supplied to the gradient amplifier. Therefore, in this case the gradient amplifier is also part of the gradient chain for which the frequency dependent impedance value is predetermined.

The feature "connected upstream to the coil" means that the gradient amplifier is positioned before the coil. In other words, the gradient waveform current passes through the gradient amplifier before it reaches the gradient coil. Therefore, the gradient amplifier processes and/or modifies the gradient waveform current prior to it being delivered to the gradient coil.

According to an embodiment of the invention, the safety monitoring method additionally comprises
measuring the temperature of the gradient coil at the set time period, and
comparing the actual output voltage with a predicted output voltage which has been measured before the set time period for a temperature range comprising the measured temperature of the gradient coil at the set time period.

Therefore, when predetermining the frequency dependent impedance value of the gradient chain by measuring transfer functions of the gradient chain before the set time period is part of the present method, this comprises measuring the temperature of the gradient chain, and predetermining the frequency dependent impedance value of the gradient chain at different temperatures of the gradient chain. In case the gradient chain used for the method comprises a gradient coil together with a gradient amplifier, the temperature of the gradient coil is used as the temperature of the gradient chain.

The primary function of this embodiment is to improve the accuracy of the voltage comparison by factoring in the temperature of the gradient coil during operation. Temperature is a critical parameter that can significantly affect the electrical properties of the gradient coil, including its impedance and the resulting output voltage. By measuring the temperature at the set time period and comparing the actual voltage with a predicted voltage that accounts for this temperature, the method ensures that any deviations detected are evaluated in the context of the current operating conditions.

The advantages of this approach are considerable. By including the temperature in the comparison process, the system can more accurately identify true faults, as opposed to normal variations in voltage that result from changes in temperature. This reduces the likelihood of false positives, where normal temperature-induced variations might otherwise be misinterpreted as faults. Additionally, this method allows for more precise and reliable fault detection, as the predicted voltage used for comparison is tailored to the specific temperature conditions at the time of monitoring. This temperature-aware monitoring enhances the overall safety of the MRI system by ensuring that corrective actions, such as shutting off the current supply, are only taken when genuinely necessary, thereby protecting the system from unnecessary interruptions and maintaining its operational integrity.

As an alternative to measuring the temperature of the gradient coil at the set time period, the temperature of the gradient coil can be predicted by a corresponding model. Such models are conventionally used to predict if a certain imaging sequence will exceed the temperature limits of the system.

The invention also relates to a computer program comprising instructions which, when the program is executed by a computer, cause the computer to carry out a method as described above. The computer program may be software available for download from a server, e.g., via the internet. Alternatively, the computer program may be a suitable (non-transitory) computer readable medium on which the instructions are stored, such as an optical storage medium or a solid-state medium, which may or may not be supplied together with or as part of other hardware.

Further, the invention relates to a computer-readable data carrier having stored thereon such a computer program.

The invention also relates to a data processing device configured for carrying out a method as described above. For example, the data processing device may comprise a processor programmed with the above computer program, or a processor (e.g. an ASIC or an FPGA) that is hardwired to carry out the above method.

The data processing device may be part of the scanner host of the magnetic resonance examination system, which has been fed with the predetermined frequency dependent impedance value of the gradient chain, which has been predetermined by measuring transfer functions of the gradient chain before the set time period. However, the data processing device may also be a standalone device which measures the actual current and voltage in the gradient chain themself.

To sum up: The present invention leverages the relationship between the input current and output voltage in a gradient chain to reliably predict expected voltages for gradient waveforms with high temporal resolution. The key to achieving this lies in accurately characterizing the frequency-dependent impedances of the gradient chain beforehand. These impedances can be understood as transfer functions that relate the frequency response of an output signal to the frequency of the input signal.

To determine the required frequency-dependent impedance, the invention proposes applying current waveforms with different frequency contents as inputs and measuring the corresponding output voltages. Since the gradient chain can be considered linear and time-invariant, this method of measuring transfer functions is sufficient to establish the impedance characteristics across a range of frequencies. Suitable waveforms for this process include, but are not limited to, triangular and trapezoidal waveforms of varying lengths and slopes, as well as chirps. These waveforms provide a diverse set of inputs that allow for a comprehensive mapping of the system's impedance.

Once the impedance is known, it becomes possible to calculate the expected output voltage for any given gradient waveform. This calculation can be performed in two different domains: the frequency domain or the time domain. In the frequency domain, the expected voltage is determined by first calculating the Fourier transform of the input signal and then applying the impedance transfer function. The result is then transformed back into the time domain to obtain the voltage profile. This approach, however, requires that the Fourier transform of the input signals be calculated in advance.

Alternatively, the convolution approach in the time domain allows for near real-time voltage prediction. In this method, the convolution kernel is derived from the Fourier transform of the impedance. The convolution of this kernel with the input signal yields the expected output voltage. This process can be efficiently implemented as a digital filter, enabling continuous calculation of output voltages with low latency. The real-time capability of this convolution approach is particularly advantageous in dynamic MR systems, where rapid and accurate voltage predictions are essential for effective safety monitoring and system control.

By employing these methods, the invention provides a robust mechanism for predicting output voltages based on the known impedance of the gradient chain, thereby enhancing the accuracy and reliability of safety monitoring in magnetic resonance examination systems. This innovation not only improves fault detection but also supports the real-time monitoring and adjustment of the system, ensuring both the safety of the MRI equipment and the well-being of patients and medical personnel.

These and other aspects of the invention will be apparent from and elucidated with reference to the embodiments described hereinafter. Such an embodiment does not necessarily represent the full scope of the invention, however.

### BRIEF DESCRIPTION OF THE DRAWINGS

Fig. 1 schematically depicts a magnetic resonance examination system with a gradient chain that comprises a gradient amplifier and a gradient coil,
Fig. 2 schematically depicts a magnetic resonance examination system with a gradient chain that only comprises a gradient coil, and
Fig. 3 schematically depicts a safety monitoring method according to an embodiment of the invention.

### DETAILED DESCRIPTION OF EMBODIMENTS

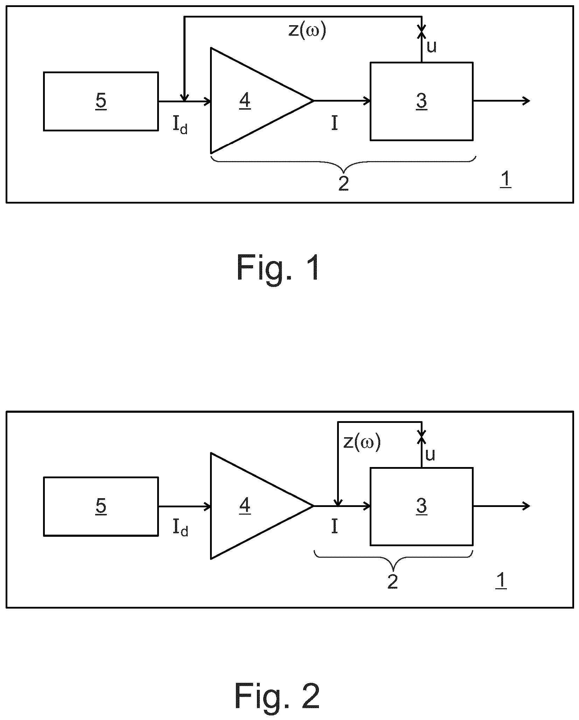

In Fig. 1, schematically a magnetic resonance examination system 1 with a gradient chain 2 that comprises a gradient amplifier 4 and a gradient coil 3 is depicted. An input gradient waveform 5 is applied to the gradient amplifier 4 (demand current I_{d}) which leads to an amplified current I which is applied from the gradient amplifier 4 to the gradient coil 3. An arrow pointing to the right hints to gradient fields generated by the gradient coil 3 in this way. Further, for the gradient chain 2, comprising the gradient coil 3 together with the gradient amplifier 4, a voltage U can be determined and a frequency-dependent impedance Z(ω). Instead and in the alternative, as depicted in Fig. 2, a frequency-dependent impedance Z(ω) may be determined for a gradient chain 2 which only comprises the gradient coil 3 itself but not the gradient amplifier 4.

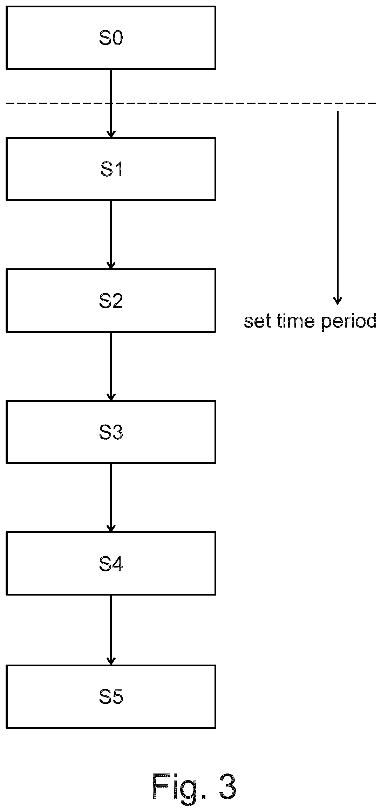

With such configurations, the following safety monitoring method for the respective gradient chain 2 of the magnetic resonance examination system 1 may be performed. This method is schematically depicted in Fig. 3.

At S1, an input gradient waveform current is applied to the gradient chain 2 of the magnetic resonance examination system 1 at a set time period, i.e. during operation of the magnetic resonance examination system 1 for examining a patient. At S2, a predicted output voltage of the gradient chain 2 which is induced by the gradient waveform current which is applied to the gradient chain 2 at the set time period is determined on the basis of a predetermined frequency dependent impedance value of the gradient chain 2 which has been predetermined by measuring transfer functions of the gradient chain 2 for different frequencies before the set time period. At S3, the actual output voltage of the gradient chain 2 which is induced by the gradient waveform current which is applied to the gradient chain 2 at the set time period is measured. Then, at S4, the actual output voltage is compared with the predicted output voltage. Finally, at S5, a corrective action is triggered in case the comparing the actual output voltage with the predicted output voltage has indicated a difference beyond a predefined admissible difference in the comparing the actual output voltage with the predicted output voltage. This corrective action may comprise triggering a current supply of the gradient chain 2 to switch off.

The frequency dependent impedance value of the gradient chain 2 has been determined in separate procedure beforehand, i.e. before the set time period at S0. The predetermining the frequency dependent impedance value of a gradient chain 2 has been performed by measuring transfer functions of the gradient chain 2 for different frequencies. This comprises applying a series of currents having different time durations as gradient waveform currents which are applied to the gradient chain 2.

The invention allows for different ways of comparing the actual output voltage with the predicted output voltage. This comparing may comprise comparing the actual output voltage with the predicted output voltage with respect to relative values of the actual output voltage and the predicted output voltage. In addition or in the alternative, this comparing may comprise comparing the actual output voltage with the predicted output voltage with respect to absolute values of the actual output voltage and the predicted output voltage. In this respect, in the comparing the actual output voltage with the predicted output voltage with respect to relative values of the actual output voltage and the predicted output voltage and/or in the comparing the actual output voltage with the predicted output voltage with respect to absolute values of the actual output voltage and the predicted output voltage, the comparison may be made in dependence on the absolute value of the current which is applied to the gradient chain 2 at the set time period. Furthermore, additional filtering and/or averaging of the deviations may be applied.

It is an option of the invention that at S0, the output voltage which has been measured before the set time period has been measured for different temperature ranges. In this way, it is possible that also the temperature of the gradient coil at the set time period is measured at S3, and that the actual output voltage is compared with a predicted output voltage which has been measured before the set time period for a temperature range comprising the measured temperature of the gradient coil at the set time period at S4.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or acts, and the indefinite article "a" or "an" does not exclude a plurality. Measures recited in mutually different dependent claims may advantageously be combined. Any reference signs in the claims should not be construed as limiting the scope. Further, for the sake of clearness, not all elements in the drawings may have been supplied with reference signs.

### REFERENCE SYMBOL LIST

- 1: magnetic resonance examination system
- 2: gradient chain
- 3: gradient coil
- 4: gradient amplifier
- 5: input gradient waveform
- I_{d}: demand current
- I: current
- U: voltage
- Z(ω): Impedance

## Claims

1. Safety monitoring method for a gradient chain (2) of a magnetic resonance examination system (1), the method comprising:
applying (S1) an input gradient waveform to the gradient chain (2) at a set time period,
determining (S2) a predicted output of the gradient chain (2) which is induced by the input gradient waveform, on the basis of a predetermined frequency dependent impedance value of the gradient chain (2) which has been predetermined by measuring transfer functions of the gradient chain (2) for different frequencies before the set time period,
measuring (S3) the actual output of the gradient chain (2) which is induced by the input gradient waveform,
comparing (S4) the actual output with the predicted output, and
triggering (S5) a corrective action in case the comparing (S4) has indicated a difference beyond a predefined admissible difference.

2. Safety monitoring method according to claim 1, wherein predetermining the frequency dependent impedance value of the gradient chain (2) is performed by measuring transfer functions of the gradient chain (2) for different frequencies before the set time period.

3. Safety monitoring method according to claim 2, wherein predetermining the frequency dependent impedance value of the gradient chain (2) by measuring transfer functions of the gradient chain (2) for different frequencies before the set time period comprises applying a series of currents having different time durations as gradient waveform currents which are applied to the gradient chain (2).

4. Safety monitoring method according to any one of claims 1 to 3, wherein the comparing the actual output with the predicted output comprises
comparing the actual output with the predicted output with respect to relative values of the actual output and the predicted output, and/or
comparing the actual output with the predicted output with respect to absolute values of the actual output and the predicted output.

5. Safety monitoring method according to claim 4, wherein in the comparing the actual output with the predicted output with respect to relative values of the actual output and the predicted output, and/or in the comparing the actual output with the predicted output with respect to absolute values of the actual output and the predicted output, a comparison is made in dependence on the absolute value of the input gradient waveform and/or the predicted output.

6. Safety monitoring method according to any one of claims 1 to 5, wherein the corrective action comprises triggering a supply of the gradient chain (2) to switch off.

7. Safety monitoring method according to any one of claims 1 to 6, the method being applied to a gradient chain (2) which comprises at least a gradient coil (3).

8. Safety monitoring method according to claim 7, wherein the gradient chain (2) comprises a gradient amplifier (4) which is connected upstream to the gradient coil (3).

9. Safety monitoring method according to any one of claims 1 to 8, additionally comprising
measuring the temperature of the gradient coil at the set time period, and
comparing the actual output with a predicted output which has been measured before the set time period for a temperature range comprising the measured temperature of the gradient coil at the set time period.

10. Computer program comprising instructions which, when the program is executed by a computer, cause the computer to carry out the method of any one of claims 1 to 9.

11. Computer-readable data carrier having stored thereon the computer program of claim 10.

12. Data processing device configured for carrying out the method of any one of claims 1 to 9.
